# EUROPEAN PATENT APPLICATION

(11) **EP 2 096 763 A1**
(43) Date of publication of application: **02.09.2009**
(21) Application number: 07850654.0
(22) Date of filing: 14.12.2007
(51) Int. Cl.: H03M 13/19

(54) **ENCODING DEVICE, ENCODING METHOD, ENCODING/DECODING DEVICE, AND COMMUNICATION DEVICE**

(30) Priority: 18.12.2006 JP 2006340239
(71) Applicant: Mitsubishi Electric Corporation, Chiyoda-ku Tokyo 100-8310 (JP)
(72) Inventor: SAKAI, Lui, Chiyoda-ku Tokyo 100-8310 (JP); MATSUMOTO, Wataru, Chiyoda-ku Tokyo 100-8310 (JP); YOSHIDA, Hideo, Chiyoda-ku Tokyo 100-8310 (JP)
(74) Representative: Pfenning, Meinig & Partner GbR
(86) International application number: PCT/JP2007/074150
(87) International publication number: WO 2008/075627

(57) **Abstract**

When carrying out puncturing of some redundant bits in an LDPC code having a check matrix of QC structure and LDGM structure, a puncture rule for preventing redundant bits which are chained to one another from being punctured is set up, and some redundant bits out of an LDPC-coded signal are punctured out of the LDPC-coded signal according to the puncture rule. As a result, redundant bits which are chained to one another can be left.

## Description

### Field of the Invention

The present invention relates to an error correction technique in digital communications. More particularly, it relates to a coding apparatus for and a coding method of generating a coded signal with an LDPC (Low-Density Parity Check: low-density parity check) code, a coding and decoding apparatus for generating a coded signal with an LDPC code, and for decoding a signal coded with an LDPC code, and a communication apparatus for generating a coded signal with an LDPC code, and for transmitting the coded signal and receiving the coded signal coded with an LDPC code.

### Background of the Invention

An LDPC code is an error correcting code having a correcting capability which comes close to the capacity of a channel, and a sparse matrix of non-zero elements (in a case of a binary matrix, "1") is used as a check matrix.
An LDPC code is called a regular LDPC code when the number of non-zero elements thereof in the direction of columns and the number of non-zero elements thereof in the direction of rows are uniform, whereas it is called a non-regular LDPC code when each weight is nonuniform. It is known that a non-regular LDPC code generally has high decoding performance.
An LDGM (Low Density Generation Matrix) structure is known as a code structure of making it easy to code an LDPC code.
An LDPC code having the LDGM structure is **characterized in that** non-zero elements of a generator matrix for generating redundant bits are arranged in the shape of steps, and generation of redundant bits in order enables the LDPC code to be processed within a linear time period.

Because a non-regular LDPC code having the LDGM structure is easy to code and has a high error correction capability, utilization of such a non-regular LDPC code having the LDGM structure for many communication fields has been studied.
Furthermore, in order to simplify the code structure and the coding, and to parallelize the coding and decoding processings, an LDPC code having a QC (Quasi-Cyclic) structure has been examined widely.
In the QC structure, a check matrix is formed by cyclicly permuting a unit matrix only the number of predefined times. By changing the size of the unit matrix according to the required number of information bits, various information bit lengths can be supported.

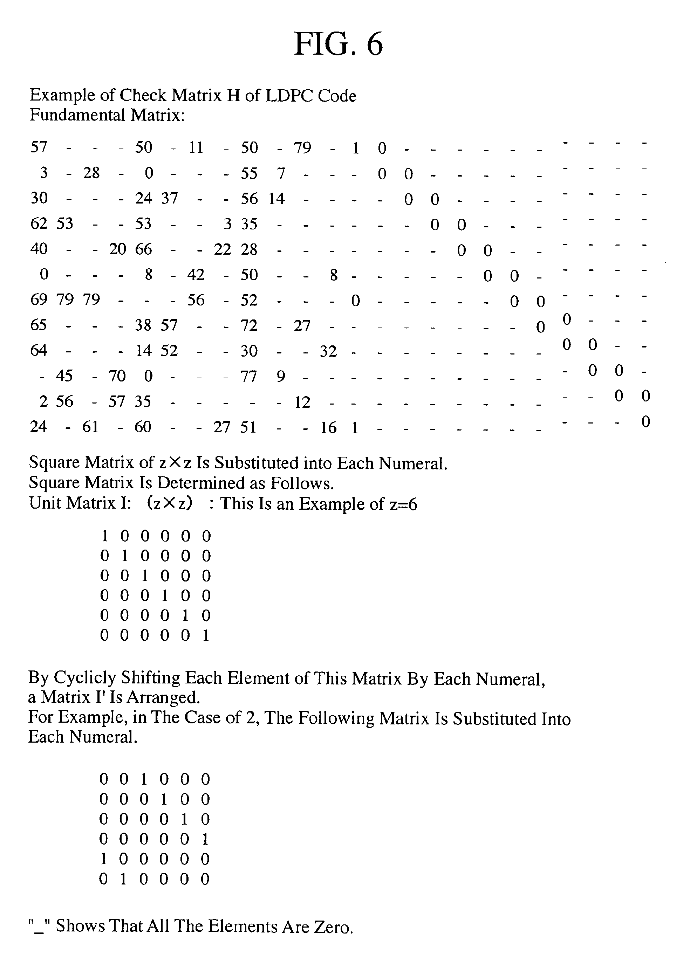

Fig. 6 is an explanatory drawing showing an example of an LDPC code having a QC structure and an LDGM structure.
In the example of Fig. 6, the coding rate is 1/2, and each number shown in the figure denotes the number of cyclic permutations which are performed on a unit matrix.
For example, "0" shows a unit matrix I, and "2" shows a matrix I' which is obtained by performing a cyclic permutation on the unit matrix I twice.
In the example of Fig. 6, a fundamental matrix of 12x24 is defined, and, as each element of the fundamental matrix, a unit matrix of z×z in which a cyclic permutation is carried out only the number of times described in the figure is placed.
The check matrix has a size of (12×z) rows and (24×z) columns, and the 13*th* to 24th rows of the fundamental matrix are associated with the generation of redundant bits.

For digital communications, one important technology is to change the number of redundant bits in a coded bit sequence which is error-correction-coded with flexibility.
In the third generation mobile communications, an HARQ (Hybid Automatic ReQuest) technology is applied and there is provided a function IR (Incremental Redundancy) of not only changing the number of redundant bits with flexibility, but also adding redundant bits of one code block to transmission data to transmit this data.
In HARQ of TypeII which is a technology of, in order to transmit data efficiently, carrying out communications using an error correcting code having a high coding rate if the state of the channel is good, whereas, if the state of the channel is bad, carrying out communications using an error correcting code having a low coding rate, and transmitting additional redundant bits when having failed in the data transmission, IR can be implemented and a high error correction capability needs to be shown at various coding rates.

As a technology of making the coding rate variable, there is a method of generating an error correcting code sequence having a low coding rate, and then carrying out puncturing according to required bits.
For example, by generating an error correcting code having a coding rate of 1/3, and then puncturing the half of the redundant bits of the error correcting code to transmit, a coded sequence having a coding rate of 1/2 is transmitted and received. The method of making the coding rate variable using puncturing is used for various error correcting codes.

The following nonpatent reference 1 discloses that the coding rate can be changed also for an LDPC code by using puncturing.
The simplest puncturing method is a method of puncturing redundant bits at equal intervals, and is used not only for an LDPC code but also for a turbo code.

[Nonpatent reference 1] Mostafa El-Khamy, Jilei Hou, Naga Bhushan, "H-ARQ Rate-Compatible Structured LDPC Codes", http://www.its.caltech.edu/∼mostafa/pubs/isit_LDPC9.pdf

Because the conventional coding apparatuses are constructed as mentioned above, they can generate a coded signal having a high coding rate easily by puncturing some redundant bits out of an LDPC code at equal intervals. A problem is, however, that when puncturing some redundant bits out of an LDPC code having a QC structure at equal intervals, a large degradation occurs in the code.
This problem will be concretely shown below.

For example, Fig. 6 shows a check matrix H having a QC structure which generates an LDPC code of a coding rate of 1/2. In particular, a case in which, when the size z of the unit matrix is an even number, the number of punctured bits is made to be equal to a multiplier of 2 by using puncturing, such as cases of a coding rate of 2/3 or 4/5, is shown as an example. In a case in which some redundant bits of an LDPC code whose coding rate is 1/2 are punctured out of the LDPC code at equal intervals so that the coding rate is made to be equal to 2/3, redundant bits are punctured out of the LDPC code every two bits (i.e., at intervals of one bit).

In this case, it should be noted that redundant bits which are generated with an LDPC code having an LDGM structure are chained to one another when generated.
For example, in the case of the LDPC code shown in Fig. 6, the (i×z+j)-*th* redundant bit is generated through an exclusive OR process including the ((i-1)×z+j)-*th* redundant bit, and the redundant bits are generated with them being chained to one another at the intervals of z.

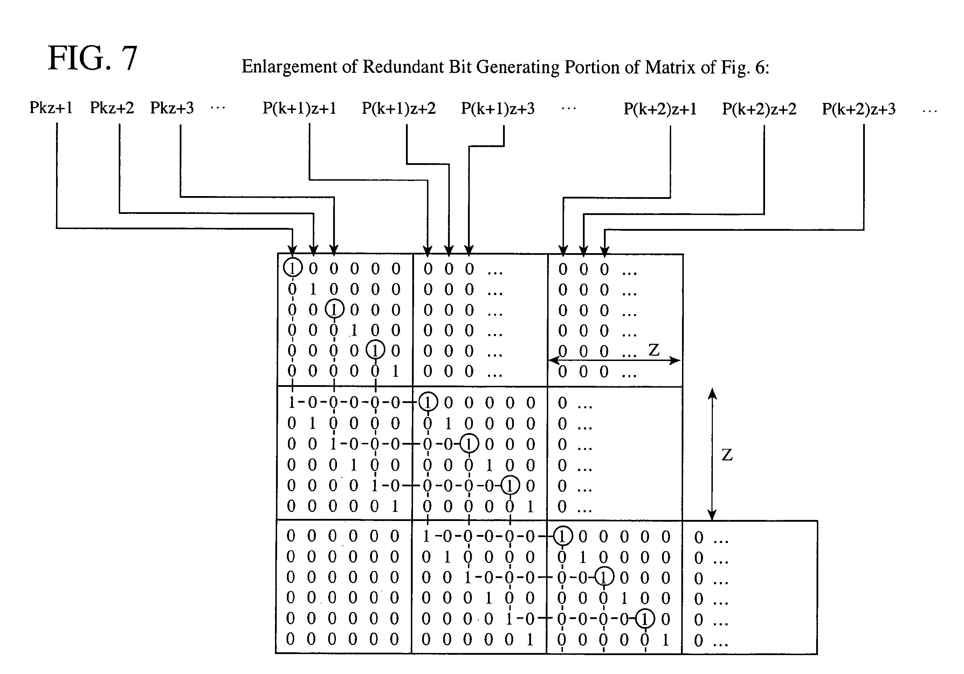

Fig. 7 is an explanatory drawing showing a correspondence between punctured bits and the check matrix.
In the example of Fig. 7, a portion associated with the generation of redundant bits (the 13*th* to 24*th* rows of the fundamental matrix are associated with the generation of the redundant bits) is extracted from the check matrix H of Fig. 6, and a case in which redundant bits are punctured out of the LDPC code having a QC structure which is constructed at z=6 every two bits is shown.
As mentioned above, redundant bits of LDGM structure are generated while they are chained to one another, and, when the size z of a unit matrix I of QC structure is an even number, all redundant bits which are chained to one another are erased if redundant bits are punctured out of the LDPC code at intervals of one bit.
In this case, information bits having no redundant bit or information bits having a part in which redundant bits are extremely few exist, and these information bits become a cause of causing performance degradation.

Until now, the example in which the size z of the unit matrix I of QC structure is an even number and puncturing is carried out at intervals of an odd number of bits is shown. Also in a case in which the size z of the unit matrix I is an odd number and puncturing is carried out at intervals of an even number of bits, redundant bits which are chained to one another are erased in the same way as that mentioned above.
As can be seen from the above description, in an LDPC code having a QC structure and an LDGM structure, puncturing of some redundant bits at equal intervals without taking into consideration the relationship between the size z of a unit matrix and the number of punctured bits results in a cause of causing large performance degradation.
For example, in a case in which the size z of the unit matrix is always defined as an even number in an LDPC code of Fig. 6, puncturing of some redundant bits at equal intervals of one bit to acquire a coding rate of 2/3 or puncturing of some redundant bits at equal intervals of three bits to acquire a coding rate of 4/5 causes a degradation in the error correction capability.

The present invention is made in order to solve the above-mentioned problems, and it is therefore an object of the present invention to provide a coding apparatus, a coding method, a coding and decoding apparatus, and a communication apparatus which can generate a coded signal of a high coding rate without causing any degradation in the error correction capability.

### Disclosure of the Invention

A coding apparatus in accordance with the present invention includes a puncture rule setting means for, when carrying out puncturing of some redundant bits in an LDPC code having a check matrix of LDGM structure, setting up a puncture rule for preventing redundant bits which are chained to one another from being punctured, and punctures redundant bits out of an LDPC-coded signal generated by an LDPC coding means according to the puncture rule set up by the puncture rule setting means.

Because the coding apparatus in accordance with the present invention includes the puncture rule setting means for, when carrying out puncturing of some redundant bits in an LDPC code having a check matrix of LDGM structure, setting up a puncture rule for preventing redundant bits which are chained to one another from being punctured, and is constructed in such a way as to puncture some redundant bits out of an LDPC-coded signal generated by the LDPC coding means according to the puncture rule set up by the puncture rule setting means, there is provided an advantage of being able to generate a coded signal having a high coding rate without causing any degradation in the error correction capability.

### Brief Description of the Figures

[Fig. 1] Fig. 1 is a configuration diagram showing a communication apparatus in accordance with Embodiment 1 of the present invention;
[Fig. 2] Fig. 2 is a flow chart showing the description of a process carried out by the communication apparatus in accordance with Embodiment 1 of the present invention;
[Fig. 3] Fig. 3 is an explanatory drawing schematically showing a reading procedure of a puncturing unit 13.
[Fig. 4] Fig. 4 is a configuration diagram showing a communication apparatus in accordance with Embodiment 4 of the present invention;
[Fig. 5] Fig. 5 is a flow chart showing the description of a process carried out by the communication apparatus in accordance with Embodiment 4 of the present invention;
[Fig. 6] Fig. 6 is an explanatory drawing showing an example of an LDPC code having a QC structure and an LDGM structure;
[Fig. 7] Fig. 7 is an explanatory drawing showing a correspondence between punctured bits and a check matrix;
[Fig. 8] Fig. 8 is an explanatory drawing showing puncturing of being able to leave redundant bits which are chained; and
[Fig. 9] Fig. 9 is an explanatory drawing showing a performance verification simulation result in Embodiment 6.

### Preferred Embodiments of the Invention

Hereafter, in order to explain this invention in greater detail, the preferred embodiments of the present invention will be described with reference to the accompanying drawings.

### Embodiment 1.

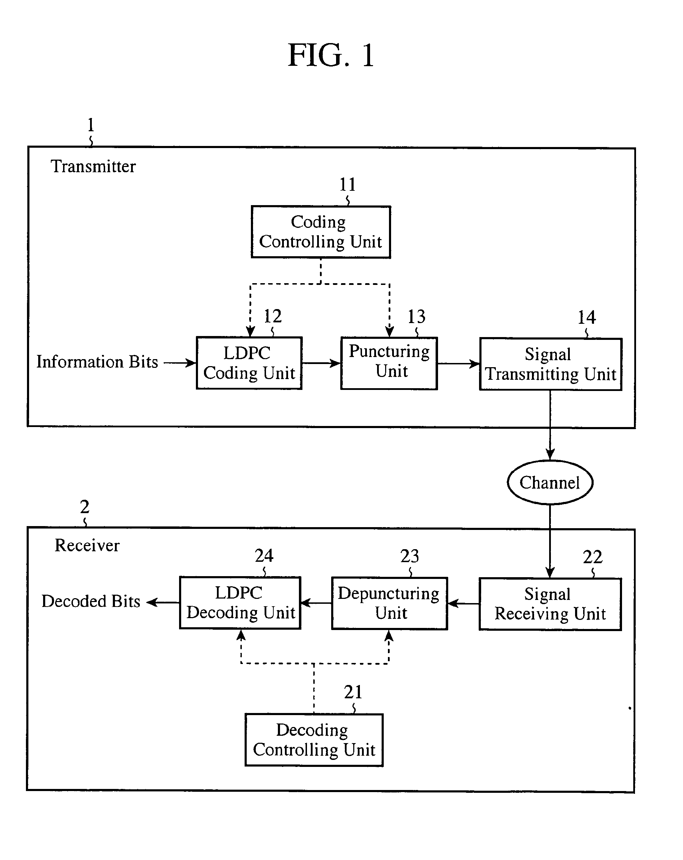

Fig. 1 is a configuration diagram showing a communication apparatus in accordance with Embodiment 1 of the present invention. In the figure, a transmitter 1 LDPC-codes information bits to generate an LDPC-coded signal, and is provided with a coding device (a coding controlling unit 11, an LDPC coding unit 12, and a puncturing unit 13) for puncturing some redundant bits of the LDPC-coded signal out of the LDPC-coded signal according to a puncture rule.
A receiver 2 depunctures an LDPC-coded signal transmitted from a transmitter 1 according to a puncture rule, and carries out LDPC decoding of the depunctured LDPC-coded signal to output information bits (decoded bits).

When carrying out puncturing of some redundant bits in an LDPC code having a check matrix H of QC structure and LDGM structure, the coding controlling unit 11 sets up a puncture pattern (a puncture rule) of preventing redundant bits which are chained to one another from being punctured. More specifically, the coding controlling unit sets up a puncture pattern of preventing redundant bits which are chained to one another at intervals equal to the size z of a unit matrix I in the check matrix H of QC structure and LDGM structure from being punctured. The coding controlling unit 11 constructs a puncture rule setting means.
The LDPC coding unit 12 carries out a process of LDPC-coding information bits to generate an LDPC-coded signal. The LDPC coding unit 12 constructs an LDPC coding means.

The puncturing unit 13 punctures some redundant bits out of the LDPC-coded signal generated by the LDPC coding unit 12 according to the puncture pattern set up by the coding controlling unit 11 so as to adjust the coding rate of the LDPC-coded signal. The puncturing unit 13 constructs a puncturing means.
A signal transmitting unit 14 carries out a process of transmitting the LDPC-coded signal punctured by the puncturing unit 13 to a channel. The signal transmitting unit 14 constructs a transmitting means.

A decoding controlling unit 21 carries out a process of setting up the same puncture pattern as the puncture pattern set up by the coding controlling unit 11. The decoding controlling unit 21 constructs the puncture rule setting means.
A signal receiving unit 22 carries out a process of receiving an LDPC-coded signal which is a transmission signal transmitted by a signal transmitting unit 14 from a channel, and calculating a received LLR (Log Likelihood Ratio: log likelihood ratio) of the LDPC-coded signal. The signal receiving unit 22 constructs a receiving means.

A depuncturing unit 23 depunctures the LDPC-coded signal received by the signal receiving unit 22 according to the puncture pattern set up by the decoding controlling unit 21. More specifically, the depuncturing unit depunctures the LDPC-coded signal received by the signal receiving unit 22 by identifying the non-punctured bits according to the same processing procedure as that which the puncturing unit 13 of the transmitter 1 follows, and returning the received LLR calculated by the signal receiving unit 22 to a bit position at which it is located immediately after coded. However, because bits which are not transmitted and received because of puncturing do not have reliability information, it is assumed that the received LLR is 0. The depuncturing unit 23 constructs a depuncturing means.
The LDPC decoding unit 24 carries out LDPC decoding of the LDPC-coded signal depunctured by the depuncturing unit 23 to output information bits (decoded bits). The LDPC decoding unit 24 constructs an LDPC decoding means.

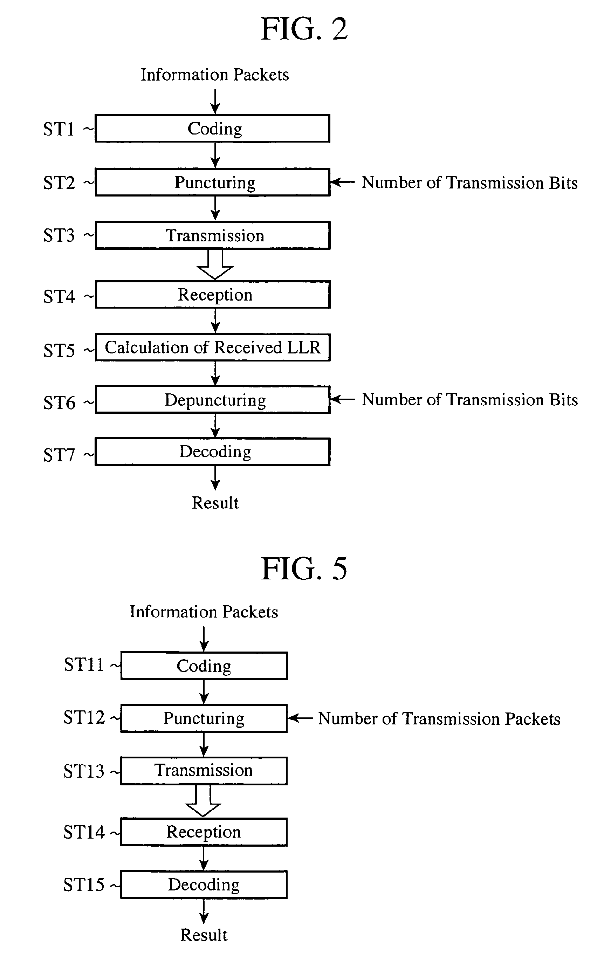

Fig. 2 is a flow chart showing the description of the process carried out by the communication apparatus in accordance with Embodiment 1 of the present invention.

Next, the operation of the communication apparatus will be explained.
When carrying out puncturing of some redundant bits in an LDPC code having a check matrix H of QC structure and LDGM structure, the coding controlling unit 11 of the transmitter 1 sets up a puncture pattern of preventing redundant bits which are chained to one another from being a punctured. More specifically, the coding controlling unit sets up a puncture pattern of preventing redundant bits which are chained to one another at intervals equal to the size z of a unit matrix I in the check matrix H of QC structure and LDGM structure from being a punctured.
Concretely, the coding controlling unit carries out the process as follows.

The coding controlling unit 11 forms a puncture pattern which does not lose all redundant bits which are chained to one another for the LDPC code having the check matrix H of QC structure. Hereafter, the process will be explained assuming that the size of the fundamental matrix is M×N, the size of the unit matrix I is z, and the number of the redundant bits r is (M-N)×z.
The coding controlling unit 11 sets the number of bits which the coding controlling unit does not puncture to T, and forms a puncture pattern which enables the puncturing unit 13 to permute the redundant bits r={rᵢ} (i=1, 2, ...) by using a replacement pattern c=c{(i)} (i=0, 1, 2, ...) as will be shown below so as to generate output bits r'={r'ᵢ} as the redundant bits which have been punctured.

```
   c=c{(i)}(i=0, 1, 2, ...) :
       For i=0 to (N-M)×z-1
          c(i)=(u×i+v) mod ((N-M)×z-1)
       End for
       c((N-M)×z-1)=(N-M)×z-1;
```

where u is an integer prime to ((N-M)×z-1), and v is an integer (0≤v<(N-M)×z).

When generating the output bits r' which are the punctured redundant bits, as will be mentioned later in detail, the puncturing unit 13 outputs the leading T bits of the output bits r' as will be shown below. 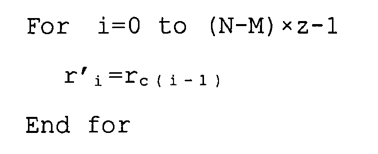 The replacement pattern c=c{(i)}(i=1, 2, ...) can also be generated as will be shown below.

```
  c=c{(i)}(i=1, 2, ...) :
       c(0)=v;
       For i=1 to (N-M)×z-1
          c(i+1)=(c(i)+u) mod ((N-M)×z-1)
       End for
       c((N-M)×z-1)=(N-M)×z-1;
```

An integer which is prime to the number (M-N)×z of the redundant bits r has a relation of being also prime to the size z of the unit matrix I, and all of the redundant bits r which are chained to one another at the regular intervals of z are not lost.

Although the method of puncturing the redundant bits at intervals having a length which is prime to the interval length z implements puncturing having good performance as mentioned above, the method has to have the step of calculating the replacement pattern and therefore a more-simplified method can be alternatively used. By changing the puncturing order in which the puncturing is performed within the unit matrix I according to the size z of the unit matrix I, a puncture pattern is formed in such a way that any of the redundant bits which are chained to one another are not lost continuously. For example, the redundant bits r are grouped by dividing the redundant bits r in units of the z-bit size of the unit matrix I, and a puncture pattern is formed for every group. At that time, by setting up the interval length of each group according to the size z of the unit matrix I in such a way as will be mentioned below to form a puncture pattern, the puncture pattern can be formed to prevent any of the redundant bits which are chained to one another from being lost continuously.

(1) When the size z is a prime number -> at equal intervals of the same length in all the groups
(2) When the number of size z is an odd number and that of the puncturing intervals is an even number
   - > at equal intervals of the same length in all the groups
(3) When the number of size z is an odd number and that of the puncturing intervals is an odd number
   - > if the number of size z and that of the puncturing intervals are prime to each other, at equal intervals of the same length in all the groups if the number of size z and that of the puncturing intervals are not prime to each other, at equal intervals of the same length in all the groups, but shifted by one bit between each group
(4) When the number of size z is an even number and that of the puncturing intervals is an odd number
   - > at equal intervals of the same length in all the groups
(5) When the number of size z is an even number and that of the puncturing intervals is an odd number
   - > at equal intervals of the same length in all the groups, but shifted by one bit between each group

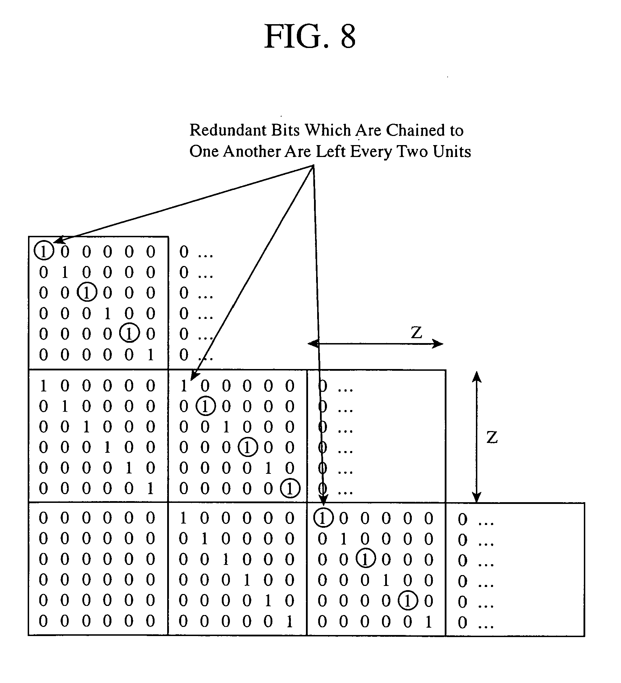

"At equal intervals of the same length in all the groups, but shifted by one bit between each group" shows that the first z-bit group is punctured at equal intervals from the leading bit in the group, and the next z-bit group is punctured at equal intervals not from the leading bit but from the next bit. Hereafter, "at equal intervals of the same length in all the groups, but shifted by one bit between each group" will be explained by taking, as an example, a case in which an LDPC code of a coding rate 1/2 shown in Fig. 6 is punctured so that a code of a coding rate 2/3 is constructed. When the half of the redundant bits generated with the coding rate of 1/2 is punctured, the punctured redundant bits have a coding rate of 2/3. As shown in Fig. 8, by puncturing the odd-numbered bits of a certain group, and also puncturing the even-numbered bits of a group adjacent to the certain group, redundant bits which are chained to one another can be left. Furthermore, even though in units of each z-bit group, all the bits of the leading group are transmitted and all the bits of the next group are punctured, redundant bits which are chained to one another can be left.

By puncturing an LDPC code having a QC structure in the above-mentioned way so as to generate an LDPC code having a high coding rate, there can be provided a high error correction capability even at various coding rates. In contrast with this, as long as the size z of the unit matrix I is defined by only a prime number, the redundant bits can be punctured at equal intervals. The design guideline of the above-mentioned puncture method can be applied to not only an LDPC code designed for an additive noise channel, such as an additive Gaussian noise channel or a phasing channel, but also an LDPC code designed for an erasure channel.

The decoding controlling unit 21 of the receiver 2 also sets up the same puncture pattern as that set up by the coding controlling unit 11 in the same way that the coding controlling unit 11 does.

When accepting information bits, the LDPC coding unit 12 of the transmitter 1 LDPC-codes the information bits at a coding rate of, for example, 1/2 so as to generate an LDPC-coded signal (step ST1). When the LDPC coding unit 12 generates the LDPC-coded signal, the puncturing unit 13 of the transmitter 1 punctures some redundant bits out of the LDPC-coded signal according to the puncture pattern set up by the coding controlling unit 11 so as to adjust the coding rate of the LDPC-coded signal (step ST2). More specifically, the puncturing unit 13 reads the redundant bits according to the following procedure in order to puncture the redundant bits so that the LDPC-coded signal has a coded bit length which is required by the communication system.

Because this Embodiment 1 is predicated on an LDPC code as shown in Fig. 6, the number of the information bits is expressed as 12xz and the coded bit length which is required by the communication system is expressed as n. Furthermore, because this Embodiment is premised on puncturing of an LDPC-coded signal having a coding rate of 1/2, the length of the redundant bits which have not been punctured yet is the same as the information bit length. Furthermore, the redundant bits generated through the LDPC coding are expressed as r={rᵢ}, a buffer for primarily storing the redundant bits is expressed as p_{k,l}, and the redundant bits which have been punctured are expressed as r'={r'ᵢ}.
In addition, in this Embodiment 1, assuming that the maximum coding rate is 8/9 and the size z of the unit matrix I is always an even number, two kinds of reading rules q^{odd} and q^{even} are made available as puncture patterns in such a way that the locations of the punctured bits are shifted between two adjacent z-bit groups.

First, the puncturing unit 13 stores the redundant bits r of the LDPC-coded signal generated by the LDPC coding unit 12 in the buffer p_{k,l} for primary storage. The puncturing unit 13 then performs a process of sequentially reading the redundant bits r' which have been punctured from the buffer p_{k,l} for primary storage, as will be shown below.

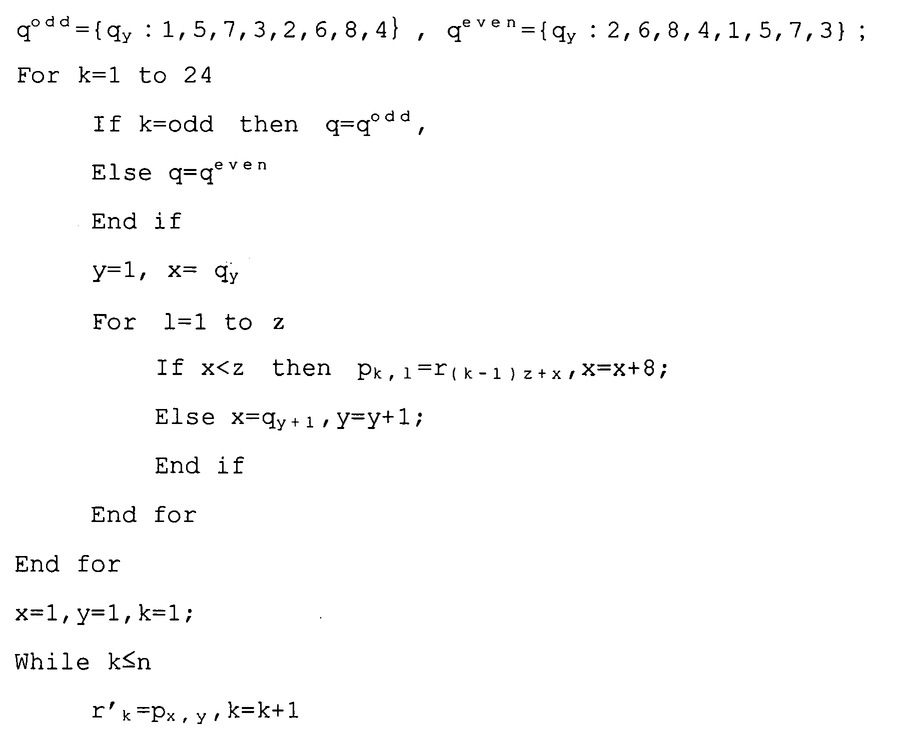

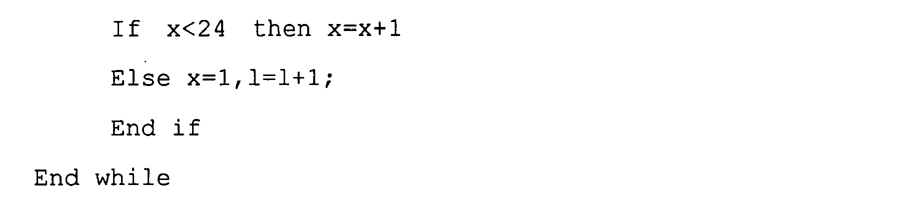

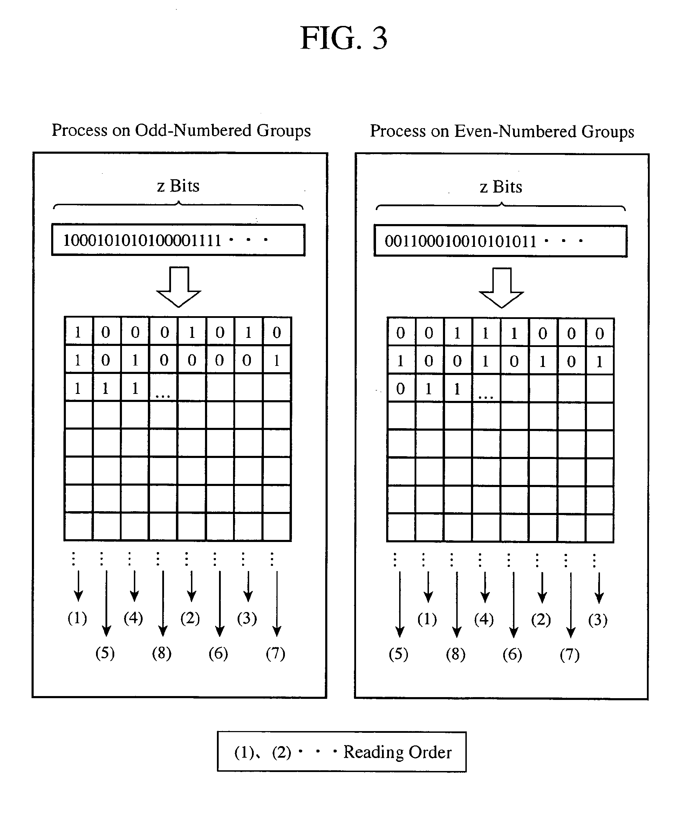

Fig. 3 is an explanatory drawing schematically showing the above-mentioned reading procedure of the puncturing unit 13. In Fig. 3, a situation in which a storage location at which a coded redundant bit string is stored is provided for each of 12 z-bit groups, and the coded redundant bit string of each group is stored in order from the first bit of each group (the coded redundant bit string is stored in order in the horizontal direction). After all the coded redundant bit strings are stored, as to each odd-numbered one of the 12 groups, the puncturing unit reads data in an order defined by the reading rule q^{odd} in the direction of columns, while as to each even-numbered one of the 12 groups, the puncturing unit reads data in an order defined by the reading rule q^{even} in the direction of columns, so that the order in which the data are outputted from each group is determined.

When the puncturing unit 13 punctures some redundant bits out of the LDPC-coded signal, the signal transmission unit 14 of the transmitter 1 modulates the punctured LDPC-coded signal so as to transmit this punctured LDPC-coded signal to a channel (step ST3). When the signal transmission unit 14 of the transmitter 1 transmits the punctured LDPC-coded signal to the channel, the signal receiving unit 22 of the receiver 2 receives the punctured LDPC-coded signal from the channel and demodulates this punctured LDPC-coded signal (step ST4), and calculates a received LLR of the demodulated LDPC-coded signal (step ST5).

The depuncturing unit 23 of the receiver 2 depunctures the LDPC-coded signal received by the signal receiving unit 22 according to the puncture pattern set up by the decoding controlling unit 21 (step ST6). More specifically, the depuncturing unit 23 depunctures the LDPC-coded signal by specifying the non-punctured bits according to the same processing procedure which the puncturing unit 13 of the transmitter 1 follows, and then returning the received LLR calculated by the signal receiving unit 22 to a bit position at which it is located immediately after coded. However, because there is no reliability information about bits on which no transmission and reception operations are performed because of the puncturing, the received LLR is 0.

When the depuncturing unit 23 depunctures the LDPC-coded signal, the LDPC decoding unit 24 carries out a process of LDPC-decoding the LDPC-coded signal to output information bits (decoded bits) (step ST7). When carrying out an IR (Incremental Redundancy) process of transmitting additional bits, the LDPC decoding unit 24 has only to sequentially output the information bits from the leading one of yet-to-be-transmitted bits of the redundant bits which are permuted in the transmission order.

As can be seen from the above description, the communication apparatus in accordance with this embodiment 1 is so constructed in such a way as to, when puncturing some redundant bits out of an LDPC code having a check matrix of QC structure and LDGM structure, set up a puncture pattern for preventing redundant bits which are chained to one another from being punctured, and puncture some redundant bits out of the LDPC-coded signal according to the puncture pattern. Therefore, the communication apparatus can leave the redundant bits which are chained to one another, and, as a result, provides an advantage of being able to generate a coded signal having a high coding rate without causing any degradation in the error correction capability.

In this Embodiment 1, puncturing of some redundant bits in an LDPC code having a check matrix of QC structure and LDGM structure is shown. As an alternative, the communication apparatus can carry out puncturing of some redundant bits in an LDPC code having a check matrix of LDGM structure. However, in this case, because an LDPC code does not have a QC structure, the coding decoding processing cannot be facilitated.

### Embodiment 2.

In above-mentioned Embodiment 1, the puncturing unit 13 of the transmitter 1 punctures some redundant bits out of an LDPC-coded signal having a coding rate of 1/2, as previously shown. In this Embodiment 2, an example in which the puncturing unit 13 of the transmitter 1 punctures some redundant bits out of an LDPC-coded signal having a coding rate of (N-M)/N will be explained.

Next, the operation of the communication apparatus will be explained. When carrying out puncturing of some redundant bits in an LDPC code having a check matrix H of QC structure and LDGM structure, the coding controlling unit 11 of the transmitter 1 sets up a puncture pattern for preventing redundant bits which are chained to one another from being punctured. More specifically, the coding controlling unit sets up a puncture pattern for preventing redundant bits which are chained to one another at regular intervals of a length equal to the size z of a unit matrix I in the check matrix H of QC structure and LDGM structure from being punctured. Concretely, this setup process is carried out as follows.

The coding controlling unit 11 forms a puncture pattern which does not lose all redundant bits which are chained to one another for an LDPC code having a check matrix H of QC structure. Hereafter, the process will be explained assuming that the size of the fundamental matrix is M×N, the size of the unit matrix I is z, and the number of the redundant bits r is (M-N)×z. The coding controlling unit 11 sets the number of bits which the coding controlling unit does not puncture to T, and forms a puncture pattern which enables the puncturing unit 13 to permute the redundant bits r={rⱼ} (i= 1, 2, ...) by using a replacement pattern c=c{(i)} (i= 0, 1, 2, ...) as will be shown below so as to generate output bits r'={r'ᵢ} as the redundant bits which have been punctured.

```
   c (0)=v;
  For i=0 to (N-M)×z-1
      c(i+1)=(c(i)+u) mod ((N-M)×z-1)
  End for
  c((N-M)×z-1)=(N-M)×z-1;
```

where u is an integer prime to ((N-M)×z-1), and v is an integer (0≤v< (N-M)×z).

When accepting information bits, the LDPC coding unit 12 of the transmitter 1 LDPC-codes the information bits at a coding rate of (N-M)/N so as to generate an LDPC-coded signal. When the LDPC coding unit 12 generates the LDPC-coded signal, the puncturing unit 13 of the transmitter 1 punctures some redundant bits out of the LDPC-coded signal according to the puncture pattern set up by the coding controlling unit 11 so as to adjust the coding rate of the LDPC-coded signal. More specifically, in order to puncture the redundant bits so that the LDPC-coded signal has a coded bit length which is required by the communication system, the puncturing unit 13 permutes the redundant bits r={rᵢ}(i=1, 2, ...) by using the above-mentioned replacement pattern c=c{(i)}(i=0, 1, 2, ...), and outputs the leading n bits of the output bits r', as will be shown below.

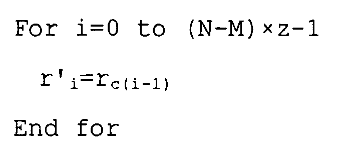

Because the process performed by the signal transmission unit 14 and subsequent processes are the same as those of above-mentioned Embodiment 1, the explanation of the processes will be omitted. This Embodiment 2 provides an advantage of being able to generate a coded signal having a high coding rate without causing any degradation in the error correction capability even when the puncturing unit 13 of the transmitter 1 punctures some redundant bits out of an LDPC-coded signal having a coding rate of (N-M)/N.

### Embodiment 3.

In above-mentioned Embodiment 1, assuming that the maximum coding rate is 8/9 and the size z of the unit matrix I is always an even number, two kinds of reading rules q^{odd} and q^{even} are made available as puncture patterns in such a way that the locations of the punctured bits are shifted between two adjacent z-bit groups, as previously shown. In contrast, this Embodiment 3 can support both a case in which the size z of the unit matrix I is an even number and a case in which the size z of the unit matrix I is an odd number. In this Embodiment 3, assuming that the maximum coding rate is 8/9 and the size z of the unit matrix I is an even or odd number, the coding controlling unit 11 provides, as puncture patterns, two kinds of reading rules q^{odd} and q^{even} in such a way that the locations of the punctured bits are shifted between two adjacent z-bit groups

When the LDPC coding unit 12 LDPC-codes information bits at a coding rate of (N-M) /N so as to generate an LDPC-coded signal, the puncturing unit 13 of the transmitter 1 punctures some redundant bits out of the LDPC-coded signal according to the puncture pattern set up by the coding controlling unit 11 so as to adjust the coding rate of the LDPC-coded signal. More specifically, the puncturing unit 13 reads the redundant bits according to the following procedure in order to puncture the redundant bits so that the LDPC-coded signal has a coded bit length which is required by the communication system.

In this Embodiment 3, the redundant bits generated through the LDPC coding are expressed as r={r₁}, a buffer for primarily storing the redundant bits is expressed as p_{k,l}, and the redundant bits which have been punctured are expressed as r'={r'₁}. First, the puncturing unit 13 stores the redundant bits r of the LDPC-coded signal generated by the LDPC coding unit 12 in the buffer p_{k,l} for primary storage. The puncturing unit 13 then performs a process of sequentially reading the redundant bits r' which have been punctured from the buffer p_{k,l} for primary storage, as will be shown below.

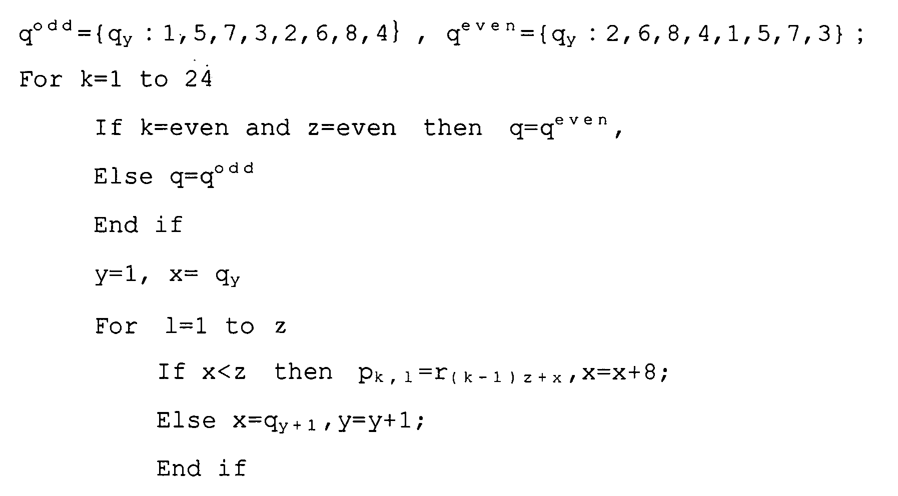

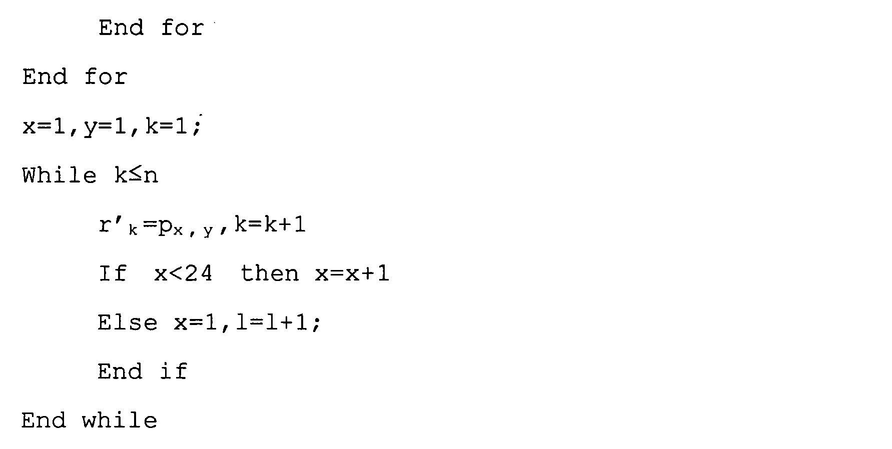

Because the process performed by the signal transmission unit 14 and subsequent processes are the same as those of above-mentioned Embodiment 1, the explanation of the processes will be omitted. This Embodiment 3 provides an advantage of being able to generate a coded signal having a high coding rate without causing any degradation in the error correction capability even when the size z of the unit matrix I is either of an even number and an odd number, like in the case of above-mentioned Embodiment 1.

### Embodiment 4.

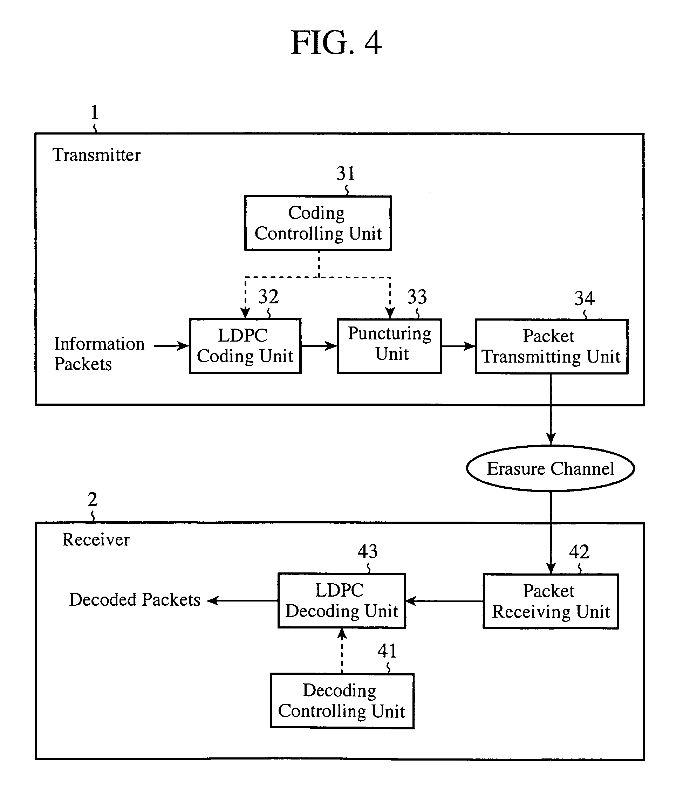

Fig. 4 is a configuration diagram showing a communication apparatus in accordance with Embodiment 4 of the present invention. In the figure, when carrying out puncturing of some redundant packets in an LDPC code having a check matrix H of QC structure and LDGM structure, a coding controlling unit 31 sets up a puncture pattern for preventing redundant packets which are chained to one another from being punctured. More specifically, the coding controlling unit sets up a puncture pattern for preventing redundant packets which are chained to one another at regular intervals of a length equal to the size z of a unit matrix I in the check matrix H of QC structure and LDGM structure from being punctured. The coding controlling unit 31 constructs a puncture rule setting means. An LDPC coding unit 32 carries out a process of LDPC-coding information packets so as to generate an LDPC-coded signal. The LDPC coding unit 32 constructs an LDPC coding means.

A puncturing unit 33 punctures the redundant packets of the LDPC-coded signal generated by the LDPC coding unit 32 according to the puncture pattern set up by the coding controlling unit 31 so as to adjust the coding rate of the LDPC-coded signal. The puncturing unit 33 constructs a puncturing means. A packet transmitting unit 34 carries out a process of transmitting the LDPC-coded signal punctured by the puncturing unit 33 to an erasure channel. The packet transmitting unit 34 constructs a transmitting means.

A decoding controlling unit 41 outputs the size z of the unit matrix I to an LDPC decoding unit 43 so as to make the LDPC decoding unit generate the same LDPC code as that transmitted by the transmitter 1. A packet receiving unit 42 carries out a process of receiving the LDPC-coded signal which is the transmission signal of the packet transmitting unit 34 from the erasure channel. An LDPC decoding unit 43 collects the rows of the check matrix which correspond to the LDPC-coded signal received by the packet receiving unit 42 and the numbers of the packets of the LDPC-coded signal so as to form a reception matrix, and decodes the reception matrix by using Gaussian elimination or the like. Fig. 5 is a flow chart showing the description of a process carried out by the communication apparatus in accordance with Embodiment 4 of the present invention.

Next, the operation of the communication apparatus will be explained. When carrying out puncturing of some redundant packets in an LDPC code having a check matrix H of QC structure and LDGM structure, the coding controlling unit 31 of the transmitter 1 sets up a puncture pattern for preventing redundant packets which are chained to one another from being punctured. More specifically, the coding controlling unit sets up a puncture pattern for preventing redundant packets which are chained to one another at regular intervals of a length equal to the size z of a unit matrix I in a check matrix H of QC structure and LDGM structure from being punctured. Concretely, this puncturing process is carried out as follows.

The coding controlling unit 31 forms a puncture pattern which does not lose all redundant packets which are chained to one another for an LDPC code having a check matrix H of QC structure. Hereafter, the process will be explained assuming that the size of the fundamental matrix is M×N, the size of the unit matrix I is z, and the number of the redundant packets r is (M-N)×z_{.}
The coding controlling unit 31 sets the number of packets which the coding controlling unit does not puncture to T, and forms a puncture pattern which enables the puncturing unit 33 to permute the redundant packets r={rᵢ} (i= 1, 2, ...) by using a replacement pattern c=c{(i)} (i= 0, 1, 2, ...) as will be shown below so as to generate output packets r'={r'ᵢ} as the redundant packets which have been punctured.

```
   c (0)=v;
  For i=0 to (N-M)×z-1
      c(i+1)=(c(i)+u) mod ((N-M)×z-1)
  End for
  c((N-M)×z-1)=(N-M)×z-1;
```

where u is an integer prime to ((N-M)×z-1) and v is an integer (0≤v<(N-M)×z).

When accepting information packets, the LDPC coding unit 32 of the transmitter 1 LDPC-codes the information packets at a coding rate of (N-M) /N so as to generate an LDPC-coded signal (step ST11). When the LDPC coding unit 32 generates the LDPC-coded signal, the puncturing unit 33 of the transmitter 1 punctures the redundant packets of the LDPC-coded signal according to the puncture pattern set up by the coding controlling unit 31 so as to adjust the coding rate of the LDPC-coded signal (step ST12). More specifically, in order to puncture the redundant packets so that the LDPC-coded signal has a coded packet length which is required by the communication system, the puncturing unit 33 permutes the redundant packets r={rᵢ}(i=1, 2, ...) by using the above-mentioned replacement pattern c=c{(i)}(i=0, 1, 2, ...), and outputs the leading T packets of the output packets r', as will be shown below.

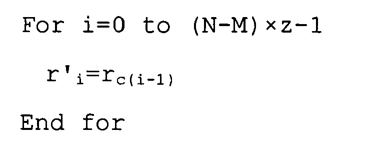

When the puncturing unit 33 punctures the redundant packets of the LDPC-coded signal, the packet transmitting unit 34 of the transmitter 1 modulates the punctured LDPC-coded signal so as to transmit the punctured LDPC-coded signal to an erasure channel (step ST13). When the packet transmitting unit 34 of the transmitter 1 transmits the punctured LDPC-coded signal to the erasure channel, the packet receiving unit 42 of the receiver 2 receives the punctured LDPC-coded signal from the erasure channel and demodulates the punctured LDPC-coded signal (step ST14). In this embodiment, it is assumed the channel is an erasure channel and all the packets of the LDPC-coded signal received by the packet receiving unit 42 are valid. For example, by adding a CRC inspection bit to each packet of the LDPC-coded signal, whether or not each packet is valid can also be judged.

When the packet receiving unit 42 receives the LDPC-coded signal, the LDPC decoding unit 43 of the receiver 2 carries out erasure decoding of the LDPC-coded signal and then outputs the decoded packets (step ST15). More specifically, the LDPC decoding unit 43 collects the rows of the check matrix which correspond to the LDPC-coded signal received by the packet receiving unit 42 and the numbers of the packets of the LDPC-coded signal so as to form a reception matrix, and decodes the reception matrix by using Gaussian elimination or the like. When carrying out an IR (Incremental Redundancy) process of transmitting additional bits, the LDPC decoding unit 43 has only to sequentially output the decoded packets from the leading one of yet-to-be-transmitted ones of the redundant packets which are permuted in the transmission order.

As can be seen from the above description, this Embodiment 4 provides an advantage of being able to generate a coded signal having a high coding rate without causing any degradation in the error correction capability even when the signal transmission unit 15 of the transmitter 1 modulates a punctured LDPC-coded signal to transmit the punctured LDPC-coded signal to an erasure channel, like in the case of above-mentioned Embodiment 1.

### Embodiment 5.

In this Embodiment 5, an example in which the communication apparatus can support both a case in which the size z of the unit matrix I is an even number and a case in which the size z of the unit matrix I is an odd number will be explained. In this Embodiment 5, assuming that the maximum coding rate is 8/9 and the size z of the unit matrix I is an even or odd number, the coding controlling unit 31 provides, as puncture patterns, two kinds of reading rules qodd and qeven in such a way that the locations of the punctured bits are shifted between two adjacent z-bit groups.

When the LDPC coding unit 32 LDPC-codes information packets at a coding rate of (N-M)/N so as to generate an LDPC-coded signal, the puncturing unit 33 of the transmitter 1 punctures the redundant packets of the LDPC-coded signal according to the puncture pattern set up by the coding controlling unit 31 so as to adjust the coding rate of the LDPC-coded signal. More specifically, the puncturing unit 33 reads the redundant packets according to the following procedure in order to puncture the redundant packets so that the LDPC-coded signal has a coded packet length n which is required by the communication system.

In this Embodiment 5, the redundant packets generated through the LDPC coding are expressed as r={r₁}, a buffer for primarily storing the redundant packets is expressed as p_{k,l}, and the redundant packets which have been punctured are expressed as r'={r'₁}. First, the puncturing unit 33 stores the redundant packets r of the LDPC-coded signal generated by the LDPC coding unit 32 in the buffer p_{k,l} for primary storage. The puncturing unit 33 then performs a process of sequentially reading the redundant packets r' which have been punctured from the buffer p_{k,l} for primary storage, as will be shown below.

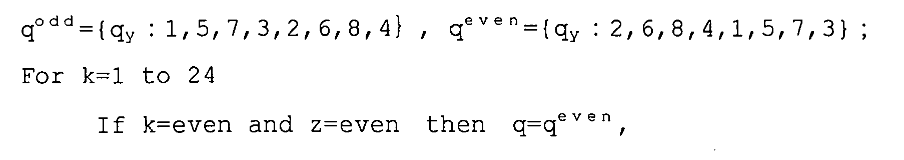

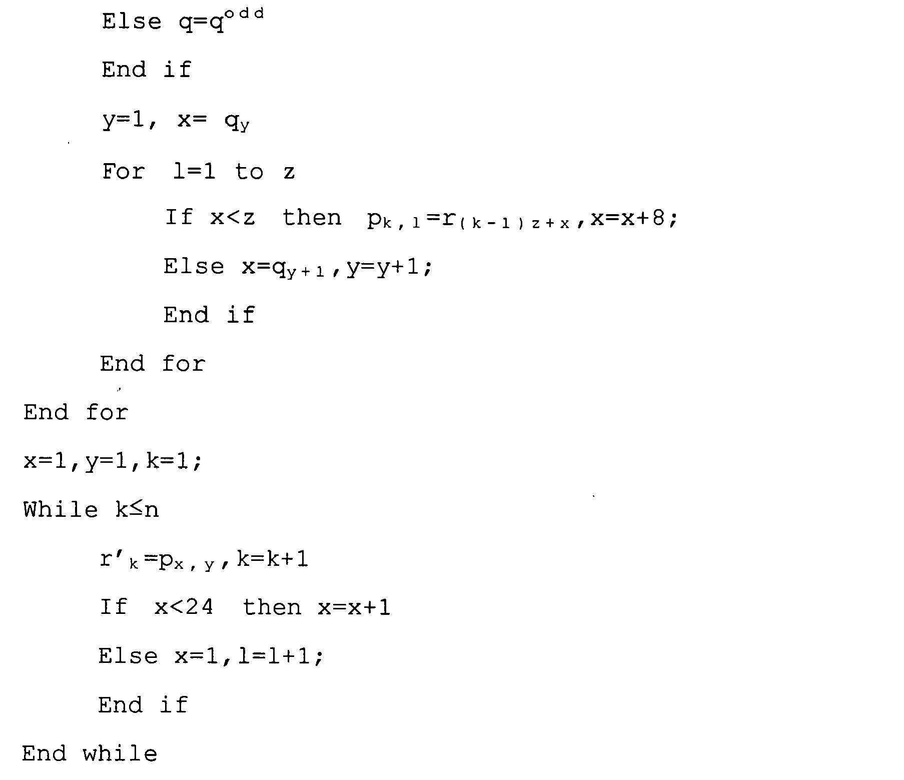

Because the process performed by the packet transmitting unit 34 and subsequent processes are the same as those of above-mentioned Embodiment 4, the explanation of the processes will be omitted. This Embodiment 5 provides an advantage of being able to generate a coded signal having a high coding rate without causing any degradation in the error correction capability even when the size z of the unit matrix I is either of an even number and an odd number, like in the case of above-mentioned Embodiment 4.

### Embodiment 6.

In this Embodiment 6, a communication apparatus which supports a case in which the size z of a unit matrix I in an LDPC code having a coding rate of 1/2 which is defined in a check matrix shown in Fig. 6 is an even number will be explained. In this Embodiment 6, assuming that the maximum coding rate is 8/9 and the size z of the unit matrix I is an even number (concretely, 24, 28, 32, 36, 40, 44, 48, 52, 56, 64, 68, 72, 76, 80, 84, 88, 92, or 96 ), the coding controlling unit 31 provides, as a puncture pattern, a reading rule l in such a way that the locations of the punctured bits are shifted between two adjacent z-bit groups.

When the LDPC coding unit 12 LDPC-codes information bits at a coding rate of 1/2 so as to generate an LDPC-coded signal, the puncturing unit 13 of the transmitter 1 punctures some redundant bits out of the LDPC-coded signal according to the puncture pattern set up by the coding controlling unit 11 so as to adjust the coding rate of the LDPC-coded signal. More specifically, the puncturing unit 13 reads the redundant bits according to the following procedure in order to puncture the redundant bits so that the LDPC-coded signal has a coded bit length n which is required by the communication system.

In this Embodiment 6, the redundant bits generated through the LDPC coding are expressed as r={rₖ}, a buffer for primarily storing the redundant bits is expressed as w_{k,l}, and the redundant bits which have been punctured are expressed as r'={r'ₖ}. First, the puncturing unit 13 stores the redundant bits r of the LDPC-coded signal generated by the LDPC coding unit 12 in the buffer w_{k,l} for primary storage. The puncturing unit 13 then performs a process of sequentially reading the redundant bits r' which have been punctured from the buffer w_{k,j} for primary storage, as will be shown below.

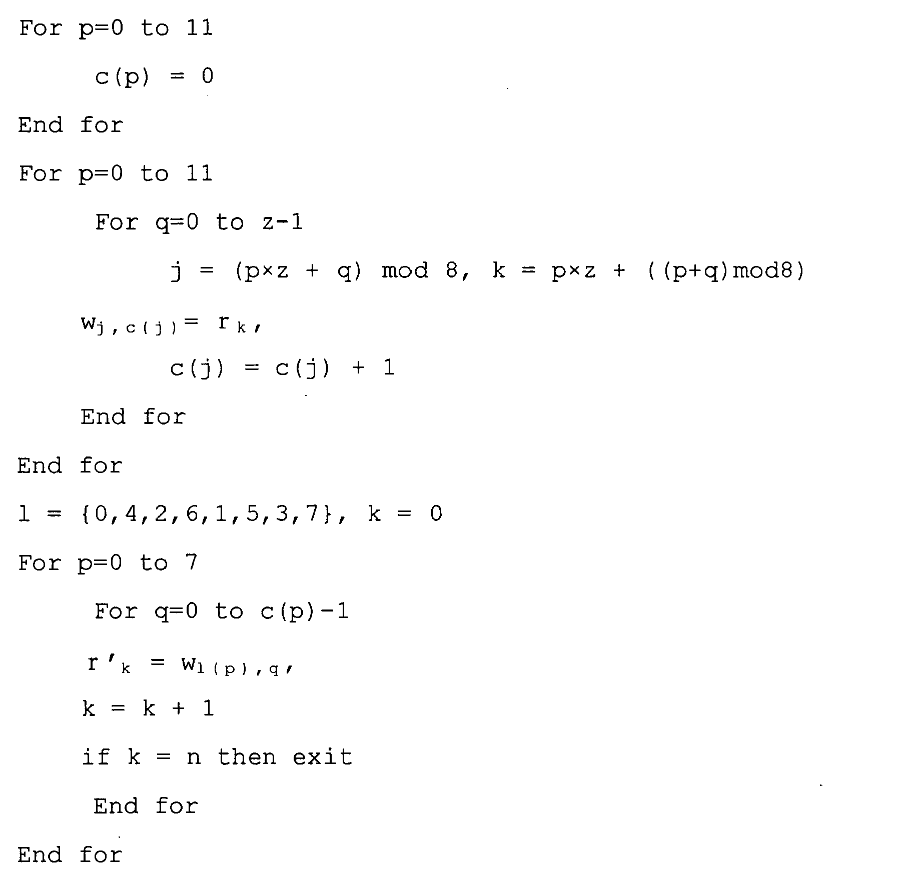

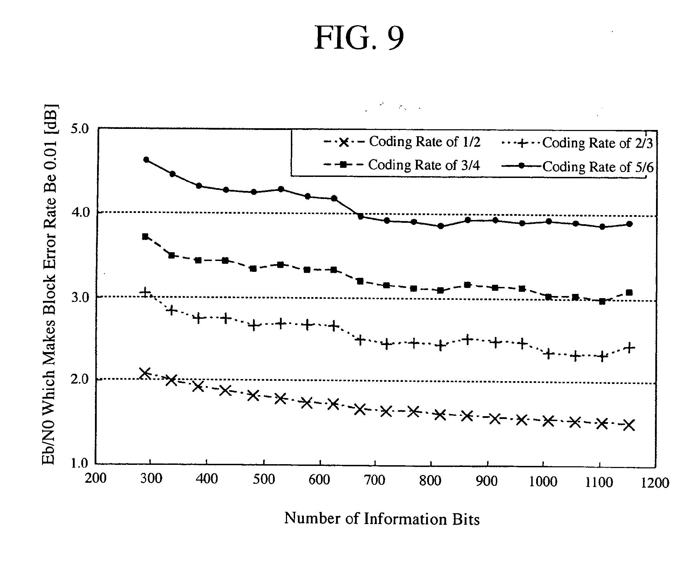

Because the process performed by the signal transmission unit 14 and subsequent processes are the same as those of above-mentioned Embodiment 1, the explanation of the processes will be omitted. Results of a verification simulation of the error correction capability at the time of practicing the puncture method according to this Embodiment 6 will be shown in Fig. 9. Fig. 9 shows cases of a coding rate of 1/2 (with no puncture), a coding rate of 2/3, a coding rate of 3/4, and a coding rate of 5/6, and, in the figure, the vertical axis shows Eb/NO at which the block error rate is 0.01, and the horizontal axis shows the number of information bits 12xz (z =24, 28, 32, 36, 40, 44, 48, 52, 56, 64, 68, 72, 76, 80, 84, 88, 92, or 96), assuming that the channel is an AWGN channel and the modulation method is QPSK modulation.

This Embodiment 6 provides an advantage of being able to generate a coded signal having a high coding rate without causing any degradation in the error correction capability in the case in which the size z of the unit matrix I is an even number (concretely, 24, 28, 32, 36, 40, 44, 48, 52, 56, 64, 68, 72, 76, 80, 84, 88, 92, or 96), like in the case of above-mentioned Embodiment 1.

### Industrial Applicability

As mentioned above, in the coding apparatus, the coding method, the coding and decoding apparatus, and the communication apparatus in accordance with the present invention, there is provided a puncture rule setting means for, when carrying out puncturing of some redundant bits in an LDPC code having a check matrix of LDGM structure, setting up a puncture rule for preventing redundant bits which are chained to one another from being punctured, and a mechanism for puncturing some redundant bits out of an LDPC-coded signal generated by an LDPC coding means according to the puncture rule set up by the puncture rule setting means. Therefore, a coded signal having a high coding rate can be generated without causing any degradation in the error correction capability, the coding apparatus, the coding method, the coding and decoding apparatus, and the communication apparatus in accordance with the present invention are suitable for use in a mobile communications system which carries out digital communications, and so on.

## Claims

1. A coding apparatus comprising:
a puncture rule setting means for, when carrying out puncturing of some redundant bits in an LDPC code having a check matrix of LDGM structure, setting up a puncture rule of preventing redundant bits which are chained to one another from being punctured;
an LDPC coding means for LDPC-coding information bits to generate an LDPC-coded signal; and
a puncturing means for puncturing redundant bits out of the LDPC-coded signal generated by said LDPC coding means according to the puncture rule set up by said puncture rule setting means.

2. A coding method comprising the steps of: when carrying out puncturing of some redundant bits in an LDPC code having a check matrix of LDGM structure, setting up a puncture rule of preventing redundant bits which are chained to one another from being punctured; LDPC-coding information bits to generate an LDPC-coded signal; and puncturing redundant bits out of said LDPC-coded signal according to said puncture rule.

3. A coding apparatus comprising:
a puncture rule setting means for, when carrying out puncturing of some redundant bits in an LDPC code having a check matrix of QC structure and LDGM structure, setting up a puncture rule of preventing redundant bits which are chained to one another from being punctured;
an LDPC coding means for LDPC-coding information bits to generate an LDPC-coded signal; and
a puncturing means for puncturing redundant bits out of the LDPC-coded signal generated by said LDPC coding means according to the puncture rule set up by said puncture rule setting means.

4. The coding apparatus according to claim 3, **characterized in that** the puncture rule setting means sets up the puncture rule of preventing redundant bits which are chained to one another at intervals of length equal to a size of a unit matrix in the check matrix of QC structure and LDGM structure from being punctured.

5. A coding method comprising the steps of: when carrying out puncturing of some redundant bits in an LDPC code having a check matrix of QC structure and LDGM structure, setting up a puncture rule of preventing redundant bits which are chained to one another from being punctured; LDPC-coding information bits to generate an LDPC-coded signal; and puncturing redundant bits out of said LDPC-coded signal according to said puncture rule.

6. The coding apparatus according to claim 5, **characterized in that** the puncture rule is the one of preventing redundant bits which are chained to one another at intervals of length equal to a size of a unit matrix in the check matrix of QC structure and LDGM structure from being punctured.

7. A coding and decoding apparatus comprising:
a puncture rule setting means for, when carrying out puncturing of some redundant bits in an LDPC code having a check matrix of LDGM structure, setting up a puncture rule of preventing redundant bits which are chained to one another from being punctured;
an LDPC coding means for LDPC-coding information bits to generate an LDPC-coded signal;
a puncturing means for puncturing redundant bits out of the LDPC-coded signal generated by said LDPC coding means according to the puncture rule set up by said puncture rule setting means; a depuncturing means for depuncturing the LDPC-coded signal punctured by said puncturing means according to the puncture rule set up by said puncture rule setting means; and
an LDPC decoding means for carrying out LDPC decoding of the LDPC-coded signal depunctured by said depuncturing means to output information bits.

8. A coding and decoding apparatus comprising:
a puncture rule setting means for, when carrying out puncturing of some redundant bits in an LDPC code having a check matrix of QC structure and LDGM structure, setting up a puncture rule of preventing redundant bits which are chained to one another from being punctured;
an LDPC coding means for LDPC-coding information bits to generate an LDPC-coded signal;
a puncturing means for puncturing redundant bits out of the LDPC-coded signal generated by said LDPC coding means according to the puncture rule set up by said puncture rule setting means; a depuncturing means for depuncturing the LDPC-coded signal punctured by said puncturing means according to the puncture rule set up by said puncture rule setting means; and
an LDPC decoding means for carrying out LDPC decoding of the LDPC-coded signal depunctured by said depuncturing means to output information bits.

9. A communication apparatus comprising:
a puncture rule setting means for, when carrying out puncturing of some redundant bits in an LDPC code having a check matrix of LDGM structure, setting up a puncture rule of preventing redundant bits which are chained to one another from being punctured;
an LDPC coding means for LDPC-coding information bits to generate an LDPC-coded signal;
a puncturing means for puncturing redundant bits out of the LDPC-coded signal generated by said LDPC coding means according to the puncture rule set up by said puncture rule setting means; a transmitting means for transmitting the LDPC-coded signal punctured by said puncturing means;
a receiving means for receiving the LDPC-coded signal transmitted from said transmitting means;
a depuncturing means for depuncturing the LDPC-coded signal punctured by said puncturing means according to the puncture rule set up by said puncture rule setting means; and
an LDPC decoding means for carrying out LDPC decoding of the LDPC-coded signal depunctured by said depuncturing means to output information bits.

10. A communication apparatus comprising:
a puncture rule setting means for, when carrying out puncturing of some redundant bits in an LDPC code having a check matrix of QC structure and LDGM structure, setting up a puncture rule of preventing redundant bits which are chained to one another from being punctured;
an LDPC coding means for LDPC-coding information bits to generate an LDPC-coded signal;
a puncturing means for puncturing redundant bits out of the LDPC-coded signal generated by said LDPC coding means according to the puncture rule set up by said puncture rule setting means;
a transmitting means for transmitting the LDPC-coded signal punctured by said puncturing means;
a receiving means for receiving the LDPC-coded signal transmitted from said transmitting means;
a depuncturing means for depuncturing the LDPC-coded signal punctured by said puncturing means according to the puncture rule set up by said puncture rule setting means; and
an LDPC decoding means for carrying out LDPC decoding of the LDPC-coded signal depunctured by said depuncturing means to output information bits.
